# EUROPÄISCHE PATENTSCHRIFT

(11) **EP 2 959 583 B1**
(45) Veröffentlichungstag und Bekanntmachung des Hinweises auf die Patenterteilung: **12.02.2020**
(21) Anmeldenummer: 13814573.5
(22) Anmeldetag: 27.12.2013
(51) Int. Cl.: H03K 17/082

(54) **SCHUTZVORRICHTUNG FÜR EINEN HALBLEITERSCHALTER UND VERFAHREN ZUM BETREIBEN EINER SCHUTZVORRICHTUNG FÜR EINEN HALBLEITERSCHALTER**
PROTECTION DEVICE FOR A SEMICONDUCTOR SWITCH, AND METHOD FOR OPERATING A PROTECTION DEVICE FOR A SEMICONDUCTOR SWITCH
DISPOSITIF DE PROTECTION POUR UN COMMUTATEUR STATIQUE ET PROCÉDÉ DE FONCTIONNEMENT D'UN DISPOSITIF DE PROTECTION POUR UN COMMUTATEUR STATIQUE

(30) Priorität: 19.02.2013 DE 102013202641
(43) Veröffentlichungstag der Anmeldung: 30.12.2015
(73) Patentinhaber: Robert Bosch GmbH, 70442 Stuttgart (DE)
(72) Erfinder: SINN, Peter, 74199 Untergruppenbach (DE); LAICH, Sebastian, 70437 Stuttgart (DE)
(86) Internationale Anmeldenummer: PCT/EP2013/078053
(87) Internationale Veröffentlichungsnummer: WO 2014/127872

(56) Entgegenhaltungen:
- EP-A2- 0 744 834
- DE-A1-102005 057 765
- DE-A1-102010 008 815
- JP-A- 2001 044 291
- US-A- 6 087 877
- US-A1- 2004 027 756
- US-B1- 6 614 633

## Beschreibung

Die vorliegende Erfindung betrifft eine Schutzvorrichtung für einen Halbleiterschalter zum Schutz vor Überspannungen, sowie ein Verfahren zum Betreiben einer Schutzvorrichtung für einen Halbleiterschalter zum Schutz vor Überspannungen.

### Stand der Technik

Die Verwendung von Halbleiterschaltern als elektrische Schaltelemente ist bekannt. Dabei kommt es bei dem Öffnen der Schaltelemente, insbesondere bei leistungselektronischen Systemen wie zum Beispiel in Gleichspannungswandlern oder Wechselrichtern, aufgrund der stets vorhandenen Streuinduktivitäten zu Überspannungen. Wird der Stromfluss durch einen Halbleiterschalter unterbrochen, so steigt an dem Halbleiterschalter zwischen Kollektor und Emitter die Spannung auf einen Wert, der größer sein kann, als die Versorgungsspannung. Überschreitet die dabei auftretende Spannung die maximale Sperrspannung des Halbleiterschalters, so kann es zur Zerstörung des Halbleiterschalters kommen.

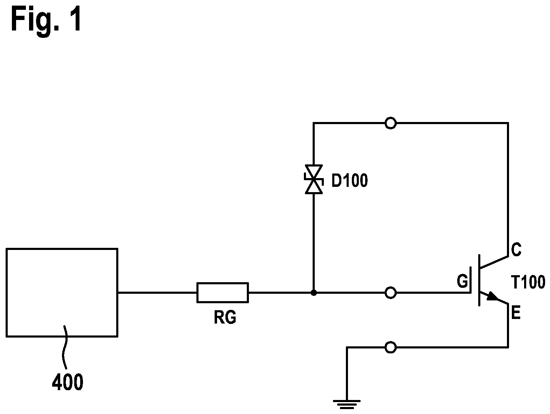

Figur 1 zeigt eine einfache Schutzschaltung zum Schutz eines Halbleiterschalters T100 vor Überspannungen. Der Halbleiterschalter T100 wird dabei über einen Gatewiderstand RG von einer gate-Treiberschaltung 400 angesteuert. Zwischen dem Kollektor C und dem Gate G des Halbleiterschaltelementes T100 ist eine Avalanche-Diode D100 angeordnet. Überschreitet die Spannung zwischen Kollektor C und Emitter E am Halbleiterschalter T100 einen durch die Avalanche-Diode D100 vorbestimmten Wert, so beginnt die Avalanche-Diode D100 zu leiten. Daraufhin öffnet sich der Halbleiterschalter T100 zumindest teilweise und wird somit geringfügig leitend. Damit reduziert sich die Abschaltgeschwindigkeit di/dt des Kollektorstroms von T100 auf ein Maß, durch das die Kollektor-Emitterspannung auf eine zulässige Höhe begrenzt wird.

Aufgrund der statischen Ausführung dieser Schaltung muss der Einsatzpunkt oberhalb der maximal möglichen Versorgungsspannung liegen. Andernfalls besteht Gefahr, dass der Halbleiterschalter T100 in einen Dauerbetrieb übergeht, was zur thermischen Zerstörung des Halbleiterschalters führen würde.

Die Druckschrift DE 10 2010 008 815 A1 offenbart einen Überspannungsschutz für einen Halbleiter. Dabei wird die Schutzschaltung für den Halbleiterschalter nur dann aktiviert, wenn an dem Halbleiterschalter tatsächlich eine Schalthandlung vorgenommen wird. Die Schutzschaltung beginnt dabei nach entsprechender Freigabe auch hierbei erst dann anzusprechen, wenn die Kollektor-Emitter-Spannung einen Schwellwert oberhalb der maximalen Versorgungsspannung übersteigt.

Die Druckschriften US 2004/0027756 A1, US 6,087,877 A, US 6,614,633 B1, JP 2001-44291 A und EP 0 744 834 A2 offenbaren jeweils eine Überspannungsschutzvorrichtung für einen Halbleiterschalter, bei der in einer einzelnen Kollektor-Gate-Verbindung selektiv Halbleiterbauelemente mit vordefinierter Durchbruchspannung zu- oder weggeschaltet werden können.

Die Offenlegungsschrift DE 10 2005 057 765 A1 offenbart eine Spannungsbegrenzungsschaltung, die zwei parallel geschaltete Zener-Dioden aufweist. Dabei ist vorgesehen, dass die eine der Zener-Dioden eine größere Durchbruchspannung aufweist als die andere der Zener-Dioden.

Es besteht daher ein Bedarf nach einem verbesserten Überspannungsschutz für Halbleiterschalter. Insbesondere besteht ein Bedarf nach einem Überspannungsschutz für Halbleiterschalter, der besonders schnell anspricht. Ferner besteht auch ein Bedarf nach einem Überspannungsschutz, bei dem ein gefährlicher Dauerbetrieb zuverlässig verhindert werden kann.

### Offenbarung der Erfindung

Eine Vorrichtung und ein Verfahren nach der Erfindung ist in den beigefügten Ansprüchen definiert.

Es ist eine Idee der vorliegenden Erfindung, den Überspannungsschutz für einen Halbleiterschalter zweistufig auszuführen. Überschreitet die Spannung an dem Halbleiterschalter einen ersten Schwellwert, so wird zunächst der Halbleiterschalter nur zeitlich begrenzt angesteuert. Durch diese zeitliche Begrenzung der Ansteuerung wird somit verhindert, dass der Halbleiterschalter bereits bei Überschreiten der ersten Spannungsschwelle in einen dauerhaft leitenden Zustand übergeht. Somit kann dieser erste Schwellwert relativ niedrig gewählt werden. Dabei ist es vorteilhaft, dass durch einen niedrig eingestellten ersten Schwellwert der erste Überspannungsschutz bereits frühzeitig anspricht und somit ein besonders schneller Schutz des Halbleiterschalters ermöglicht wird.

In einer zweiten Stufe wird der Halbleiterschalter dann dauerhaft angesteuert, sobald die Spannung an dem Halbleiterschalter einen zweiten Schwellwert übersteigt. Dabei ist es vorteilhaft, dass der Halbleiterschalter zuvor bereits durch den ersten Überspannungsschutz zeitlich begrenzt angesteuert wurde und somit der Steuereingang (das Gate) des Halbleiterschalters durch diese erste Ansteuerung bereits vorkonditioniert ist. Somit kann beim Ansprechen des zweiten Überspannungsschutzes der Halbleiterschalter besonders schnell in einen leitenden Zustand überführt werden. Dies führt zu einem rascheren Ansprechen des Überspannungsschutzes. Die Spitzenwerte der transienten Überspannungspulse, wie sie bei Abschaltvorgängen auftreten, fallen aufgrund des schnelleren Ansprechens dabei deutlich geringer aus.

In einer Ausführungsform ist der erste Schwellwert kleiner als der zweite Schwellwert. Somit wird beim Überschreiten des ersten, kleineren Schwellwertes der Halbleiterschalter zunächst zeitlich begrenzt angesteuert und das Gate des Halbleiterschalters erhält dabei bereits eine Vorspannung. Beim Überschreiten des zweiten, größeren Schwellwertes wird dann ein besonders schneller Überspannungsschutz erreicht.

Erfindungsgemäß umfasst die Schutzvorrichtung einen Schaltdetektor, der dazu ausgestaltet ist, eine Schalthandlung an dem Halbleiterschalter zu erkennen. Somit ist es möglich, durch das Erkennen einer Schalthandlung am Halbleiterschalter besonders rasch auf zu erwartende Überspannungen zu reagieren, bzw. den Überspannungsschutz nur auf Zeitintervalle nach einer Schalthandlung zu begrenzen.

Erfindungsgemäß ist der Schaltdetektor dazu ausgestaltet, den ersten Überspannungsschutz in einen aktiven Zustand zu versetzen, wenn der Halbleiterschalter geöffnet wird. Somit kann das Ansprechen des Überspannungsschutzes auf einen Zeitraum nach einer Schalthandlung am Halbleiterschalter beschränkt werden.

Erfindungsgemäß ist der Schaltdetektor dazu ausgestaltet, den ersten Überspannungsschutz in einen inaktiven Zustand zu versetzen, solange der Halbleiterschalter geschlossen oder vollständig abgeschaltet ist. Hierdurch wird ein Ansprechen des Überspannungsschutzes aufgrund externer Ereignisse vermieden. Ein Ansprechen des Halbleiterschalters aufgrund anderer Ereignisse wird somit ausgeschlossen.

Gemäß einer weiteren Ausführungsform ist der Halbleiterschalter ein bipolarer Transistor mit einem isolierten Gate (IGBT) oder ein MOSFET.

Die vorliegende Erfindung umfasst ferner einen Wechselrichter mit einem Halbleiterschalter, der eine Schutzvorrichtung gemäß einer Ausführungsform der vorliegenden Erfindung umfasst.

Erfindungsgemäß umfasst das Verfahren einen Schritt zum Erkennen einer Schalthandlung an dem Halbleiterschalter, wobei der Schritt zum Ansteuern des Halbleiterschalters für eine vorbestimmte Zeit nur dann ausgeführt wird, wenn eine Schalthandlung an dem Halbleiterschalter erkannt wird.

Weitere Merkmale und Ausführungsformen ergeben sich aus der Beschreibung im Zusammenhang mit der beigefügten Zeichnung.

Kurze Beschreibung der Figuren

Es zeigen:
Figur 1: eine schematische Darstellung eines Schaltbilds für eine Schutzschaltung eines Halbleiterschalters zum Schutz vor Überspannungen;
Figur 2: eine schematische Darstellung eines Schaltbilds einer Schutzvorrichtung für einen Halbleiterschalter gemäß einer Ausführungsform der vorliegenden Erfindung; und
Figur 3: eine schematische Darstellung eines Verfahrens zum Betreiben einer Schutzschaltung für einen Halbleiterschalter gemäß einer weiteren Ausführungsform der vorliegenden Erfindung.

### Beschreibung von Ausführungsformen

Halbleiterschalter im Sinne der vorliegenden Erfindung sind alle Arten von Schaltelementen, bei denen auf Basis einer Halbleiterstruktur eine elektrische Verbindung geschlossen oder geöffnet werden kann. Das Öffnen und Schließen des Halbleiterschalters erfolgt dabei durch Ansteuerung des Halbleiterschalters mittels eines elektrischen Signals. Halbleiterschalter im Sinne der vorliegenden Erfindung sind insbesondere MOSFET oder IGBT (Insulated Gate Bipolar Transistor). Darüber hinaus ist die erfindungsgemäße Schutzvorrichtung ebenso auf alle anderen Arten von Halbleiterschaltern anwendbar.

Auch wenn die vorliegende Schutzvorrichtung im Zusammenhang mit Halbleiterschaltern beschrieben wurde, ist sie darüber hinaus ebenso auf alle anderen Schaltelemente anwendbar, bei denen ein Schutz vor Überspannung beim Schließen des Schaltelements erreicht werden soll.

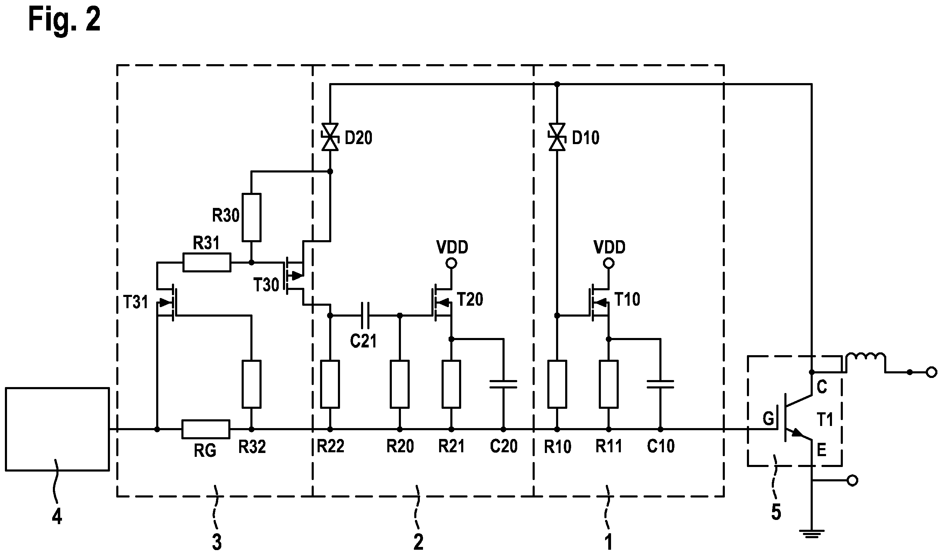

Figur 2 zeigt die schematische Darstellung eines Schaltbilds einer Schaltvorrichtung für einen Halbleiterschalter gemäß einer Ausführungsform der vorliegenden Erfindung. Der Halbleiterschalter 5 wird dabei durch einen Transistor T1 gebildet. Durch Anlegen eines geeigneten Steuersignals am Gate G kann dabei zwischen Kollektor C und dem Emitter E eine elektrisch leitende Verbindung geöffnet oder geschlossen werden. Das Gate G des Halbleiterschalters 5 wird von einem Steuersignal angesteuert, das ein Gatetreiber 4 über einen Gatewiderstand RG am Gate G des Halbleiterschalters 5 bereitstellt. Auf diese Weise kann der Halbleiterschalter 5 geöffnet oder geschlossen werden.

Zum Schutz des Halbleiterschalters 5 vor Überspannungen zwischen dem Emitter E und dem Kollektor C umfasst der Überspannungsschutz einen ersten Schaltungsteil 1, der das Gate G des Halbleiterschalters 5 dann ansteuert, wenn die Spannung U_{CE} zwischen Kollektor C und Emitter E des Halbleiterschalters 5 einen vorgegebenen Schwellwert übersteigt. Dieser Schwellwert wird durch das Halbleiterelement D10 vorgegeben. Bei dem Halbleiterelement D10 kann es sich beispielsweise um eine geeignete Avalanche-Diode, eine Zener-Diode oder ein anderes Bauelement handeln, das oberhalb einer definierten Durchbruchspannung reversibel von einem sperrenden in einen leitenden Zustand übergeht. Das Halbleiterelement D10 ist zwischen dem Kollektor C des Halbleiterschalters 5 und dem Steuereingang eines Transistors D10 angeordnet.

Überschreitet die Spannung U_{CE} an dem Halbleiterschalter 5 den durch das Halbleiterelement D10 vorgegebenen Schwellwert, so wird der Transistor D10 angesteuert und geht in einen leitenden Zustand über. Hierdurch wird das Gate G des Halbleiterschalters 5 angsteuert und der Halbleiterschalter 5 geht daraufhin in einen zumindest geringfügig leitenden Zustand über. Aufgrund des sich daraufhin einstellenden Stromes zwischen Kollektor C und Emitter E am Halbleiterschalter 5 verringert sich daraufhin auch die Kollektor-Emitterspannung U_{CE} des Halbleiterschalters 5. Durch geeignete Wahl des Widerstandes R11 und des dazu parallel geschalteten Kondensators C10 zwischen dem Transistor T10 und dem Gate G des Halbleiterschalters 5 kann das Ansteuerverhalten beim Auftreten von Überspannungen gezielt eingestellt werden.

Die Schutzvorrichtung umfasst darüber hinaus weiterhin einen dynamischen Überspannungsschutz 2. Der Schwellwert für die minimale Kollektor-Emitterspannung U_{CE} des Halbleiterschalters 5 wird dabei durch das Halbleiterbauelement D20 bestimmt. Bei dem Halbleiterbauelement D20 kann es sich analog zum Halbleiterbauelement D10 um eine Zener-Diode, eine Avalanche-Diode oder ein anderes Bauelement handeln, das bei einer vorgegebenen Spannung reversibel von einem sperrenden in einen leitenden Zustand übergeht. Nach dem Überschreiten des Schwellwertes der Kollektor-Emitter-Spannung U_{CE} an dem Halbleiterschaltelement 5 beginnt das Halbleiterbauelement D20 zu leiten. Daraufhin wird über den Kondensator C21 der Transistor T20 angesteuert. Dies führt im Weiteren dazu, dass beim Öffnen des Transistors T20 das Gate G des Halbleiterschalters 5 angesteuert wird und der Halbleiterschalter 5 daraufhin zumindest geringfügig in einen leitenden Zustand übergeht.

Zwischen dem Transistor T20 dem Gate des Halbleiterschalters 5 ist dabei eine Parallelschaltung des Widerstands R21 und des Kondensators C20 angeordnet. Durch diese Bauelemente kann das Ansteuersignal beim Ansprechen des dynamischen Überspannungsschutzes 2 geformt werden.

Durch den Kondensator C21, der zwischen dem spannungsbegrenzenden Halbleiterbauelement D20 und dem Steuersignal-Eingang des Transistors T20 angeordnet ist, wird die Zeitdauer für die Ansteuerung durch den dynamischen Überspannungsschutz 2 begrenzt. Daher wird die Ansteuerung des Halbleiterschalters 5 auch bei einer Überschreitung des Schwellwertes oberhalb der durch das Halbleiterbauelement D20 vorgegebenen Schwelle wieder abfallen, wenn die durch den Kondensator C21 vorgegebene Zeitdauer überschritten wird, selbst wenn zu diesem Zeitpunkt die Kollektor-Emitter-Spannung U_{CE} am Halbleiterschalter 5 den durch das Halbleiterbauelement D20 vorgegebenen Schwellwert noch überschreitet.

Steigt die Kollektor-Emitterspannung U_{CE} am Halbleiterschalter 5 noch weiter an, so liegt aufgrund der zeitlich begrenzten Ansteuerung durch den dynamischen Überspannungsschutz 2 am Gate G des Halbleiterschalters 5 bereits eine Vorspannung an. Daher kann bei einem nachgeschalteten Ansprechen des statischen Überspannungsschutzes 1 oberhalb der durch das Halbleiterbauelement D10 vorgegebenen Spannung ein Ansteuern des Gates G des Halbleiterschalters 5 durch den statischen Überspannungsschutz 1 deutlich schneller zu einem Öffnen des Halbleiterschalters 5 führen. Dieses besonders schnelle Ansprechen des Halbleiterschalters 5 führt dazu, dass die transienten Überspannungsspitzen der Kollektor-Emitterspannung U_{CE} deutlich geringer ausfallen, als dies ohne das vorherige Ansteuern durch den dynamischen Überspannungsschutz 2 der Fall wäre.

Da die Ansteuerung des dynamischen Überspannungsschutzes 2 durch den Kondensator C21 gezielt zeitlich begrenzt werden kann, besteht somit keine Gefahr, dass der dynamische Überspannungsschutz 2 zu einem dauerhaften Ansteuern des Halbleiterschalters 5 führt. Daher kann für das Halbleiterbauelement D20 eine Schwellspannung gewählt werden, die unterhalb der maximalen Betriebsspannung des Halbleiterschalters 5 liegt. Hierdurch wird ein besonders frühzeitiges Ansprechen des Überspannungsschutzes ermöglicht.

Die erfindungsgemäße Schutzvorrichtung umfasst darüber hinaus auch einen Schaltungsteil 3, der das Ansprechen des dynamischen Überspannungsschutzes 2 weiter limitiert. Hierdurch wird beispielsweise ermöglicht, dass der dynamische Überspannungsschutz 2 nur dann anspricht, wenn eine detektierte Überspannung auch aus einer Schalthandlung durch den Gatetreiber 4 herrührt. Insbesondere wenn der Schwellwert für das Ansprechen des dynamischen Überspannungsschutzes unterhalb der maximalen Betriebsspannung liegt, kann somit zu Zeiten außerhalb von Schalthandlungen verhindert werden, dass der dynamische Überspannungsschutz anspricht, wenn die Spannung an dem Halbleiterschalter nahe der maximalen Betriebsspannung liegt und somit das Halbleiterbauelement D20 ein Ansprechen des Schutzes auslösen würde.

Hierzu wird durch den Schaltungsabschnitt 3 ein Schaltdetektor gebildet, der einen Spannungsabfall über dem Gatewiderstand RG zwischen dem Gatetreiber 4 und dem Gate G des Halbleiterschalters 5 auswertet. Auf diese Weise wird der dynamische Überspannungsschutz 2 mittels der Transistoren T30 und T31 nur dann aktiviert, wenn tatsächlich ein Abschaltvorgang des zu schützenden Halbleiterschalters 5 Ursache für eine Überspannung zwischen Kollektor C und Emitter E am Halbleiterschalter 5 ist. Andernfalls bleibt die Schaltung inaktiv. Das Öffnen des Halbleiterschalters 5 wird somit auf die Zeitpunkte nach einer Schalthandlung des Gatetreibers 4 begrenzt.

Die erfindungsgemäße Schutzvorrichtung zum Schutz eines Halbleiterschalters vor Überspannungen kann dabei überall eingesetzt werden, wo Halbleiterschalter vor transienten Überspannungen nach Schaltvorgängen geschützt werden sollen. Insbesondere kann die erfindungsgemäße Überspannungsschutzvorrichtung beispielsweise bei Gleichspannungskonvertern mit Halbleiterschaltern oder auch bei Wechselrichtern mit Halbleiterschaltern eingesetzt werden. Ferner kann ein erfindungsgemäßer Überspannungsschutz beispielsweise bei Wechselrichtern zur Ansteuerung von elektrischen Antrieben Verwendung finden, da in derartigen Aufbauten parasitäre Induktivitäten bei Schalthandlungen zu hohen Überspannungen führen können.

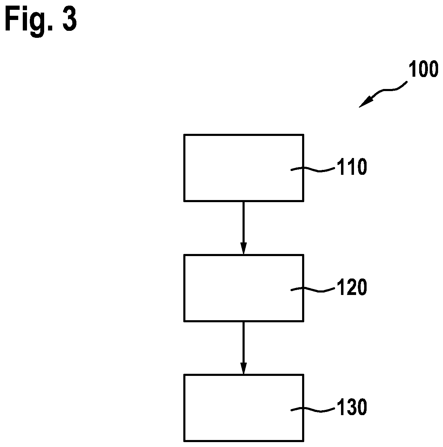

Figur 3 zeigt eine schematische Darstellung eines Verfahrens 100 zum Betreiben einer Schutzschaltung für einen Halbleiterschalter. In einem Schritt 110 wird dabei eine Schalthandlung am Halbleiterschalter 5 erkannt. Beispielsweise kann dies eine Änderung des Signals aus einem Gatetreiber 4 sein, die vom Schaltdetektor 3 erkannt wird. Daraufhin gibt dieser Schaltdetektor 3 einen ersten Überspannungsschutz 2 frei. In einem weiteren Schritt 120 wird daraufhin der Halbleiterschalter 5 für eine vorbestimmte Zeitdauer angesteuert, wenn eine Spannung U_{CE} an dem Halbleiterschalter 5 einen ersten Schwellwert übersteigt. Nach dieser vorbestimmten Zeitdauer wird der Halbleiterschalter 5 selbst dann nicht angesteuert, wenn die Spannung U_{CE} den ersten Schwellwert übersteigt.

In einem weiteren Schritt 130 wird ferner der Halbleiterschalter 5 so lange angesteuert, solange die Spannung U_{CE} an dem Halbleiterschalter 5 einen zweiten Schwellwert übersteigt. Dieses Ansteuern des Halbleiterschalters 5 oberhalb des zweiten Schwellwertes erfolgt dabei ohne zeitliche Begrenzung. Daher ist für den zweiten Schwellwert eine Spannung zu wählen, die oberhalb der maximalen Betriebsspannung liegt, um ein dauerhaftes Ansteueren des Halbleiterschalters 5 zu vermeiden und somit einer thermischen Zerstörung des Halbleiterschalters 5 vorzubeugen.

Zusammengefasst betrifft die vorliegende Erfindung eine Schutzvorrichtung für einen Halbleiterschalter mit einem verbesserten Ansprechverhalten. Die Schutzvorrichtung umfasst neben einer statischen Komponente ferner eine dynamische Komponente und eine Auswertung von Schalthandlungen an dem Halbleiterschalter. Die dynamische Komponente des Überspannungsschutzes spricht bei einer geringeren Überspannung an, ist darüber hinaus jedoch im Ansprechverhalten zeitlich begrenzt. Ferner kann das Ansprechen der dynamischen Komponente des Überspannungsschutzes auch darauf begrenzt werden, dass ein Ansprechen nur nach Schalthandlungen am Halbleiterschalter erfolgt.

## Patentansprüche

1. Schutzvorrichtung für einen Halbleiterschalter (5), wobei ein Gate (G) des Halbleiterschalters (5) von einem Steuersignal ansteuerbar ist, das ein Gatetreiber (4) über einen Gatewiderstand (RG) am Gate (G) des Halbleiterschalters (5) bereitstellt, mit
einem ersten Überspannungsschutz (2), der dazu ausgestaltet ist, den Halbleiterschalter (5) für eine vorbestimmte Zeitdauer anzusteuern, wenn eine Spannung (U_{CE}) zwischen einem Kollektor (C) und einem Emitter (E) des Halbleiterschalters (5) einen ersten Schwellwert übersteigt;
einem zweiten Überspannungsschutz (1), der dazu ausgestaltet ist, den Halbleiterschalter (5) anzusteuern, wenn die Spannung (U_{CE}) an dem Halbleiterschalter (5) einen zweiten Schwellwert übersteigt; und mit
einem Schaltdetektor (3), der dazu ausgestaltet ist, einen Abschaltvorgang an dem Halbleiterschalter (5) anhand eines Spannungsabfalls über dem Gatewiderstand (RG) zu erkennen, den ersten Überspannungsschutz (2) durch Transistoren (T30,T31) in einen aktiven Zustand zu versetzen, wenn der Halbleiterschalter (5) geöffnet wird, und in einen inaktiven Zustand, solange der Halbleiterschalter (5) geschlossen oder vollständig geöffnet ist, wobei
der erste Überspannungsschutz (2) ein erstes Halbleiterbauelement (D20) aufweist, welches reversibel von einem sperrenden in einen leitenden Zustand übergeht, wenn die Spannung (U_{CE}) an dem Halbleiterschalter (5) den ersten Schwellwert übersteigt, und welches zwischen dem Kollektor (C) des Halbleiterschalters (5) und dem Gate (G) des
Halbleiterschalters (5) angeordnet ist,
der zweite Überspannungsschutz (1) ein zweites Halbleiterbauelement (D10) aufweist, welches reversibel von einem sperrenden in einen leitenden Zustand übergeht, wenn die Spannung (U_{CE}) an dem Halbleiterschalter (5) den zweiten Schwellwert übersteigt, und welches zwischen dem Kollektor (C) des Halbleiterschalters (5) und dem Gate (G) des Halbleiterschalters (5) parallel zu dem Halbleiterbauelement (D20) des ersten Überspannungsschutzes (2) angeordnet ist.

2. Schutzvorrichtung nach Anspruch 1, wobei der erste Schwellwert kleiner ist als der zweite Schwellwert.

3. Schutzvorrichtung nach einer der vorherigen Ansprüche 1 bis 3, wobei der Halbleiterschalter (5) ein bipolarer Transistor mit einem isolierten Gate oder ein MOSFET ist.

4. Wechselrichter mit einem Halbleiterschalter (5), der eine Schutzvorrichtung nach einem der vorherigen Ansprüche aufweist.

5. Verfahren zum Betreiben einer Schutzvorrichtung für einen Halbleiterschalter (5) nach einem der Ansprüche 1 bis 3, mit den Schritten:
Ansteuern (120) des Halbleiterschalters (5) für eine vorbestimmte Zeitdauer, wenn die Spannung (U_{CE}) an dem Halbleiterschalter (5) den ersten Schwellwert übersteigt;
Ansteuern (130) des Halbleiterschalters (5), solange die Spannung (U_{CE}) an dem Halbleiterschalter (5) den zweiten Schwellwert übersteigt;
Erkennen (110) einer Schalthandlung an dem Halbleiterschalter (5),
wobei der Schritt (120) zum Ansteuern des Halbleiterschalters (5) für eine vorbestimmte Zeit nur ausgeführt wird, wenn eine Schalthandlung an dem Halbleiterschalter (5) erkannt wird.

## Claims

1. Protection device for a semiconductor switch (5), wherein a gate (G) of the semiconductor switch (5) can be controlled by a control signal which is provided by a gate driver (4) at the gate (G) of the semiconductor switch (5) via a gate resistor (RG), having first overvoltage protection (2) which is configured to control the semiconductor switch (5) for a predetermined period if a voltage (U_{CE}) between a collector (C) and an emitter (E) of the semiconductor switch (5) exceeds a first threshold value;
second overvoltage protection (1) which is configured to control the semiconductor switch (5) if the voltage (U_{CE}) across the semiconductor switch (5) exceeds a second threshold value; and having
a switching detector (3) which is configured to detect a switch-off process at the semiconductor switch (5) on the basis of a voltage drop across the gate resistor (RG), to change the first overvoltage protection (2) to an active state by means of transistors (T30, T31) if the semiconductor switch (5) is opened, and to an inactive state as long as the semiconductor switch (5) is closed or completely open, wherein
the first overvoltage protection (2) has a first semiconductor component (D20) which reversibly changes from an off state to an on state if the voltage (U_{CE}) across the semiconductor switch (5) exceeds the first threshold value and which is arranged between the collector (C) of the semiconductor switch (5) and the gate (G) of the semiconductor switch (5),
the second overvoltage protection (1) has a second semiconductor component (D10) which reversibly changes from an off state to an on state if the voltage (U_{CE}) across the semiconductor switch (5) exceeds the second threshold value and which is arranged between the collector (C) of the semiconductor switch (5) and the gate (G) of the semiconductor switch (5) in parallel with the semiconductor component (D20) of the first overvoltage protection (2).

2. Protection device according to Claim 1, wherein the first threshold value is lower than the second threshold value.

3. Protection device according to one of the preceding Claims 1 to 3, wherein the semiconductor switch (5) is an insulated gate bipolar transistor or a MOSFET.

4. Inverter having a semiconductor switch (5) which has a protection device according to one of the preceding claims.

5. Method for operating a protection device for a semiconductor switch (5) according to one of Claims 1 to 3, having the steps of:
controlling (120) the semiconductor switch (5) for a predetermined period if the voltage (U_{CE}) across the semiconductor switch (5) exceeds the first threshold value;
controlling (130) the semiconductor switch (5) as long as the voltage (U_{CE}) across the semiconductor switch (5) exceeds the second threshold value;
detecting (110) a switching action at the semiconductor switch (5),
wherein the step (120) for controlling the semiconductor switch (5) for a predetermined time is carried out only if a switching action is detected at the semiconductor switch (5).

## Revendications

1. Dispositif de protection pour un commutateur à semi-conducteurs (5), dans lequel une grille (G) du commutateur à semi-conducteurs (5) peut être commandée par un signal de commande qui est fourni par un circuit d'attaque de grille (4) par l'intermédiaire d'une résistance de grille (RG) à la grille (G) du commutateur à semi-conducteurs (5), comportant
une première protection contre les surtensions (2) qui est conçue pour commandera le commutateur à semi-conducteurs (5) pendant une période de temps prédéterminée lorsqu'une tension (U_{CE}) entre un collecteur (C) et un émetteur (E) du commutateur à semi-conducteurs (5) dépasse une première valeur de seuil ; une seconde protection contre les surtensions (1) qui est conçue pour commander le commutateur à semi-conducteurs (5) lorsque la tension (U_{CE}) au niveau du commutateur à semi-conducteurs (5) dépasse une seconde valeur de seuil ; et comportant
un détecteur de commutation (3) qui est conçu pour détecter une opération de déconnexion au niveau du commutateur à semi-conducteurs (5) sur la base d'une chute de tension à travers la résistance de grille (RG), afin de faire passer la première protection contre les surtensions (2) dans un état actif au moyen de transistors (T30, T31) lorsque le commutateur à semi-conducteurs (5) est ouvert, et dans un état inactif tant que le commutateur à semi-conducteurs (5) est fermé ou entièrement ouvert, dans lequel
le premier dispositif de protection contre les surtensions (2) comprend un premier composant à semi-conducteurs (D20) qui passe de manière réversible d'un état bloquant à un état conducteur lorsque la tension (U_{CE}) au niveau du commutateur à semi-conducteurs (5) dépasse la première valeur de seuil, et qui est disposé entre le collecteur (C) du commutateur à semi-conducteurs (5) et la grille (G) du commutateur à semi-conducteurs (5),
la seconde protection contre les surtensions (1) comporte un second composant à semi-conducteurs (D10) qui passe de manière réversible d'un état bloquant à un état conducteur lorsque la tension (U_{CE}) au niveau du commutateur à semi-conducteurs (5) dépasse la seconde valeur de seuil, et qui est disposé entre le collecteur (C) du commutateur à semi-conducteurs (5) et la grille (G) du commutateur à semi-conducteurs (5) en parallèle avec le composant à semi-conducteurs (D20) de la première protection contre les surtensions (2).

2. Dispositif de protection selon la revendication 1, dans lequel la première valeur de seuil est inférieure à la seconde valeur de seuil.

3. Dispositif de protection selon l'une des revendications 1 à 3 précédentes, dans lequel le commutateur à semi-conducteurs (5) est un transistor bipolaire à grille isolée ou un MOSFET.

4. Onduleur comprenant un commutateur à semi-conducteurs (5) qui comporte un dispositif de protection selon l'une des revendications précédentes.

5. Procédé de fonctionnement d'un dispositif de protection pour un commutateur à semi-conducteurs (5) selon l'une des revendications 1 à 3, comprenant les étapes suivantes :
la commande (120) du commutateur à semi-conducteurs (5) pendant une période de temps prédéterminée lorsque la tension (U_{CE}) au niveau du commutateur à semi-conducteurs (5) dépasse la première valeur de seuil ;
la commande (130) du commutateur à semi-conducteurs (5) tant que la tension (U_{CE}) du commutateur à semi-conducteurs (5) dépasse la seconde valeur de seuil ;
la détection (110) d'une opération de commutation au niveau du commutateur à semi-conducteurs (5),
dans lequel l'étape (120) de commande du commutateur à semi-conducteurs (5) pendant une période de temps prédéterminée n'est effectuée que lorsqu'une opération de commutation est détectée au niveau du commutateur à semi-conducteurs (5).
